# EUROPEAN PATENT APPLICATION

(11) **EP 4 753 217 A1**
(43) Date of publication of application: **03.06.2026**
(21) Application number: 25214137.9
(22) Date of filing: 07.11.2025
(51) Int. Cl.: H04L 25/02, H03G 1/00, H04L 25/03

(54) **CIRCUIT AND METHOD**

(30) Priority: 30.11.2024 IN 202441094194
(71) Applicant: NXP B.V., 5656 AG Eindhoven (NL)
(72) Inventor: Singh, Prashant, 5656 AG Eindhoven (NL)
(74) Representative: Schmütz, Christian Klaus Johannes

(57) **Abstract**

An attenuator includes passgates for providing attenuation of received signals at desired frequencies. The passgates are controlled by source followers implemented with transistors that receive the differential signals at their control terminals. Current provided to the source follower transistors can be set to provide an attenuation level at a desired frequency to offset the effects of the communications channel and parasitics of the receiver. In some embodiments, the current provided to the source follower transistors maybe programmable.

## Description

### Field

The present disclosure relates to an attenuator with a passgate.

### Background

Communication system utilize receivers to receive information sent over a communications channel. The channel characteristics can effect the quality of the signals received. The effect of the channel characteristics may be compounded by limitations of the receiver circuitry.

### Brief Description of the Drawings

The present disclosure may be better understood, and its numerous objects, features, and advantages made apparent to those skilled in the art by referencing the accompanying drawings.
Figure 1 is a block diagram of a communications system.
Figure 2 is a circuit diagram of a prior art linear equalization that is utilized in a receiver.
Figure 3 is a graph showing a frequency response of a prior art receiver with respect to gain.

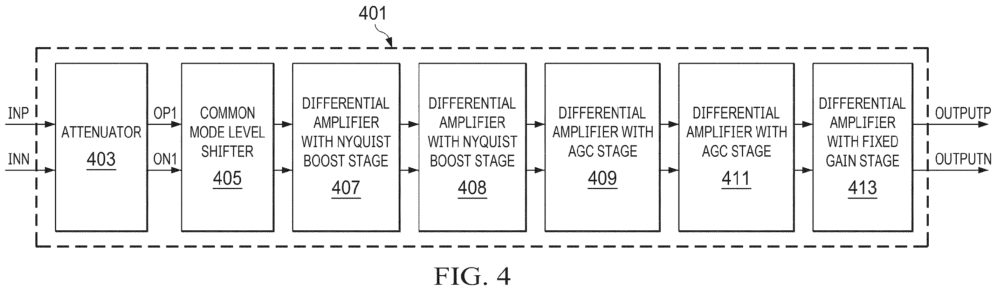

Figure 4 is a circuit diagram of a receiver according to one embodiment of the present disclosure.
Figure 5 is a circuit diagram of an attenuator according to one embodiment of the present disclosure.
Figure 6 is a circuit diagram of a programmable current source circuit according to one embodiment of the present disclosure.
Figure 7 is a table showing the effects of programmable settings of a programmable current source circuit according to one embodiment of the present disclosure.
Figure 8 shows two frequency response graphs of a receiver according to one embodiment of the present disclosure.

The use of the same reference symbols in different drawings indicates identical items unless otherwise noted. The Figures are not necessarily drawn to scale.

### Detailed Description

The following sets forth a detailed description of a mode for carrying out the invention. The description is intended to be illustrative of the invention and should not be taken to be limiting.

As disclosed herein, an attenuator includes passgates for providing attenuation of received signals at desired frequencies. The passgates are controlled by source followers implemented with transistors that receive the differential signals at their control terminals. Current provided to the source follower transistors can be set to provide an attenuation level at a desired frequency to offset the effects of the communications channel and parasitics of the receiver. In some embodiments, the current provided to the source follower transistors maybe programmable.

In some embodiments, utilizing passgates for signal attenuation provides for an attenuator that may not require capacitors or large resistors for shaping the frequency response of a received signal. Such an attenuator may have reduced parasitics and may occupy less integrated circuit space.

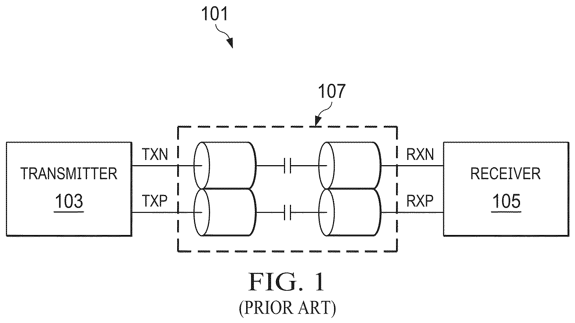

Figure 1 is a simplified block diagram of a standard communications system 101. System 101 includes a transmitter 103 that transmits differential signals TXN and TXP over a "wired" communication channel (represented by block 107) where the signals outputted by the channel are shown as differential signals RXN and RXP. Signals RXN and RXP are provided to receiver 105 for processing to extract the information encoded therein by transmitter 103.

In a communication system, channel characteristics affect the quality of the signals received from a communications channel. The effects of the channel characteristics may vary based on power, frequency, channel length, channel medium type, as well as channel interference from external sources. For high speed applications (e.g., above 1 GHz) with short channels (e.g., less than 3 mm trace length), signal reflection may become the dominant source of data eye closure of a differential signal at a receiver. To mitigate data eye closure and other issues, a linear equalizer configured to provide a negative Nyquist boost may be utilized in one or more gain stages of a receiver.

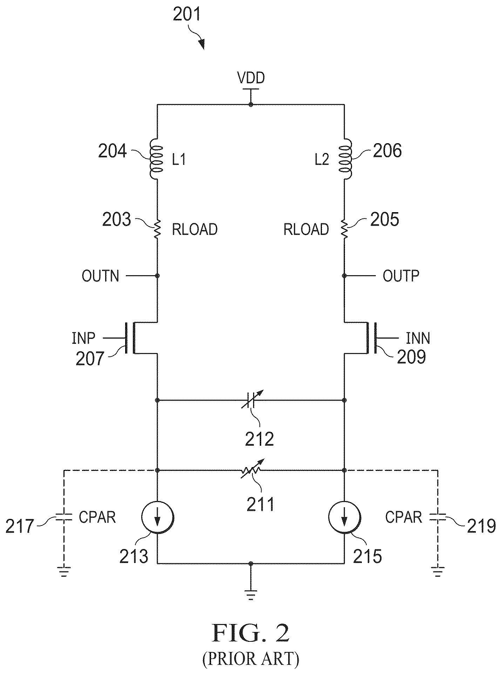

Figure 2 is a circuit diagram of a prior art continuous time linear equalizer 201 configured to provide a negative Nyquist boost which that may be utilized in an amplifier stage of a receiver. Equalizer 201 includes inputs to receive signals INP and INN at the gates of NFETs 207 and 209, and includes outputs at the drains of NFETs 207 and 209 to provide output signals OUTN and OUTP, respectively. Equalizer 201 includes load resistors 203 and 205, load inductors 204 and 206, programmable resistor circuit 211, programmable capacitance circuit 212, and current sources 213 and 215.

With such an equalizer, the adjustment of the capacitance of capacitance circuit 212 and the resistance of resistor circuit 211 can be used to lower the gain and broaden the circuits bandwidth by adding a zero to provide a negative Nyquist boost. Such adjustments can be beneficial in adjusting the receiver to compensate for the effects of a short channel (e.g., less than a 3 mm circuit board trace). However, in a low gain mode, the generated zero along with the parasitic capacitances 217 and 219 of equalizer 201 can cause a "gain bump" in the frequency response at high frequencies. Such a gain bump deteriorates a desired flatness in the gain response of a receiver. Furthermore, parasitics of an amplifier stage (e.g., parasitic capacitances 217 and 219) may amplify a gain bump induced in a previous amplifier stage such that the overall gain bump increases as the signals propagate down a series of stages.

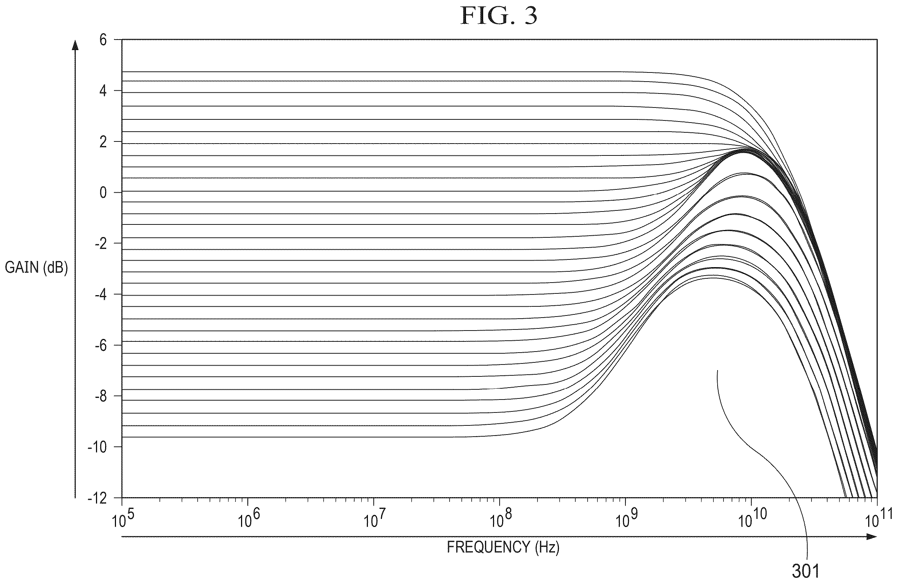

Figure 3 is a graph of a frequency response of a prior art receiver. For lower gains (e.g., below 2 dB) there is gain bump 301 in the frequency response that occurs at higher frequencies (e.g., starting at around 8 GHz to 10.4 GHz for the lower gain values in Figure 3) such that it distorts the gain flatness of the receiver which is desired at those frequencies. See for example for gains above 4 dB in Figure 3 having a desired "flatter" frequency response at the higher frequencies.

To address this gain bump issue, some prior art receivers implement a programmable low pass filter (not shown) at the front end of the receiver. The low pass filter includes programable resistances and capacitances to tune a signal to reduce or eliminate the gain bump at the desired frequencies. Typically, these programmable resistances are located in line and the programmable capacitances are connected between the signal line and ground in a typical RC low pass filter configuration (although some capacitances may be located in line as well).

However, such a programmable RC low pass filters may cause several issues such as providing sources of parasitics in the signal path due to multiple resistive paths and parasitics due to the switches. Furthermore, at high frequencies and low output impedances, the size of the resistances and capacitances may be relatively large, requiring large IC surface space or large IC package components. Accordingly, such prior art attenuators may be undesirable for at least these reasons.

Figure 401 is a block diagram of a receiver 401 according to one embodiment of the present disclosure. In the embodiment shown, receiver 401 includes input terminals to receive signals INP and INN that are differential to each other. In one embodiment, signals INP and INN may be received directly from a wired communications channel (e.g., a cable, strip line, or PCB trace - not shown) or via front end circuitry (not shown) connected to the channel. In some embodiments, the channel may be a wireless channel. In some embodiments, INP and INN implement a serial data signal that conveys digital data values. The signals may be clocked or self-timed. In still other embodiments, the differential signal may be another type of signal such as an analog signal or a multi bit digital signal. In some embodiments, the channel and signals may be implemented as a SerDes communications system such as a PCIe, USB 3.2, or DP communications system.

Receiver 401 includes an attenuator 403 that receives the INP and INN differential signals and attenuates the signals using passgates so as to remove or minimize a gain bump in the frequency response of the receiver output at higher frequencies. The output of attenuator 403 (differential signals OP1 and ON1) are provided to a common mode level shifter 405. The output of level shifter 405 is provided to a gain stage 407 that includes a differential amplifier with programmable Nyquist boost (similar to the linear equalizer of Figure 2). The output of stage 407 is providing another stage 408 similar stage 407. The output of stage 408 is provided to stage 409 that includes a differential amplifier with an automatic gain control (AGC). The output of stage 409 is provided to stage 411, which is similar to stage 409. The output of stage 411 is provided to stage 413 which has a differential amplifier with a fixed gain. The output of stage 413 (OUTPUTP, OUTPUTN) includes data that is provided to other circuitry (not shown) for further processing.

Stages 407, 408, 409, 411, and 413 include parasitics that amplify the high frequency gain boost at low frequency gain values produced by the equalizers of stages 407, 408,409, and 411. However, attenuator 403 shapes the frequency response of the received signals to minimize the parasitic, high frequency gain bump at the output signal (OUTPUTP, OUTPUTN).

In other embodiments, a receiver may have other configurations, other types of stages, a different number of stages, and/or operate differently in other embodiments. Also in some embodiments, a receiver maybe implemented in a transceiver device that includes a transmitter for transmitting signals over the channel, including over the same signal lines. The transmitter and the receiver of such a circuit may share circuitry for performing their functions.

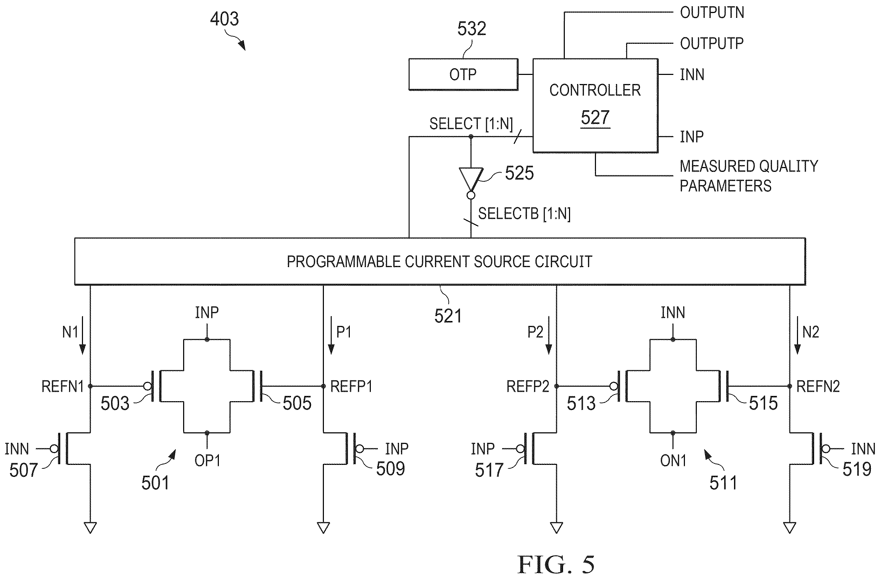

Figure 5 is a circuit diagram of attenuator 403 according to one embodiment of the present disclosure. Attenuator 403 includes passgate 501 for attenuating the input signal INP to provide the output signal OP1 and passgate 511 for attenuating the input signal INN signal to provide the output signal ON1.

Passgate 501 includes PFET 503 and NFET 505 connected in parallel where current terminals (source, drain) of each transistor are connected together. An input current terminal of passgate 501 receives the INP signal and the output current terminal of passgate 501 provides the OP1 signal.

The gate voltage of PFET 503 is controlled by the output voltage (REFN1) of a source follower that includes PFET 507. The input of the source follower (the gate of PFET 507) receives the input signal INN. Programmable current source circuit 521 provides a current (N1) for the source follower, where the amount of current provided controls the voltage differential between the source follower output (REFN1) and source follower input (INN).

The gate voltage of NFET 505 is controlled by the output voltage (REFP1) of a source follower that includes PFET 509. The input of the source follower (the gate of PFET 509) receives the input signal INP. Programmable current source circuit 521 provides a current (P1) for the source follower, where the amount of current provided controls the voltage differential between the source follower output (REFP1) and source follower input (INP).

Passgate 511 includes PFET 513 and NFET 515 connected in parallel where current terminals (source, drain) of each transistor are connected together. An input current terminal of passgate 511 receives the INN signal and the output current terminal of passgate 511 provides the ON1 signal.

The gate voltage of PFET 513 is controlled by the output voltage (REFP2) of a source follower that includes PFET 517. The input of the source follower (the gate of PFET 517) receives the input signal INP. Programmable current source circuit 521 provides a current (P2) for the source follower, where the amount of current provided controls the voltage differential between the source follower output (REFP2) and source follower input (INP).

The gate voltage of NFET 515 is controlled by the output voltage (REFN2) of a source follower that includes PFET 519. The input of the source follower (the gate of PFET 519) receives the input signal INN. Programmable current source circuit 521 provides a current (N2) for the source follower, where the amount of current provided controls the voltage differential between the source follower output (REFN2) and source follower input (INN).

In the embodiment shown, attenuator 403 includes a controller 527 that provides a multibit signal (SELECT[1:N]) to control the current amounts of N1, P1, P2, and N2 to control the voltage differentials between the source follower inputs (INP and INN) and outputs (REFN1, REFP1, REFP2, and REFN2). The voltage differentials control the amount of attenuation provided by passgates 501 and 511. Circuit 521 receives the SELECT signal and an inverse of the SELECT signal (SELECTB[1:N]), which is provided by a multibit invertor circuit 525.

In the embodiment shown, controller 527 includes inputs for receiving the output signals OUTPUTN and OUTPUTP, which controller 527 uses to determine measured quality parameters of the received signals such as e.g., data jitter, signal to noise ratio , bit error rate, data eye height, and data eye width. Controller 527 may also include inputs for receiving signals INP and INN, which it can use to determine at least some measured quality parameters. In other embodiments, controller includes an input to receive indications of measured quality parameters from other circuits of receiver 401. Controller 527 may also have an input from OTP circuit 532 that includes commands or current settings in a one-time programmable memory (e.g., fuses, ROM) for setting current values that maybe programmed during system manufacture. In such embodiments, the current values would be fixed upon programming. In other embodiments, controller 527 may include an input from a system processor (not shown) to receive commands from the system processor for setting the source follower currents. In other embodiments, the currents N1, P1, N2, P2 would not be programmable.

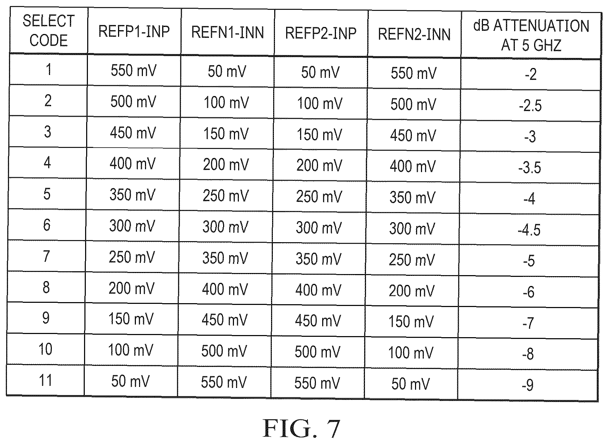

During operation, the source followers (implemented with PFETs 507, 509, 517, and 519) provide a voltage at their outputs (REFN1, REFP1, REFP2, and REFN2, respectively) that is a voltage differential higher than the voltage of the input signals (INN, INP, INP, and INN, respectively) applied to their inputs (the gates of PFET 507, PFET 509, PFET 517, and PFET 519, respectively). The magnitude of the voltage differentials is dependent on the current amounts of currents N1, P1, P2, and N2, respectively, as well as the voltage levels of the input signals INN and INP. In some embodiments, the magnitude of a voltage differential increases or decreases with the changing voltage of the input signals (INN and INP) as the gain of the source follower may not be linear. Also as shown in Figure 5, the minimum voltage value of the source follower outputs (REFN1, REFP1, REFP2, and REFN2) are set at current defined voltage differentials of the source followers above ground (e.g., see the Table of Figure 7). The magnitude of the voltage differentials at source follower outputs REFN1 and REFP1 determine the amount of attenuation provided by passgate 501 to input signal INP in producing OP1, and the magnitude of the voltage differentials at source follower outputs REFP2 and REFN2 determine the amount of attenuation provided by passgate 511 to input signal INN in producing ON 1.

In some embodiments during operation, the voltages of INP and INN continuously transition between a high data state, positive voltage (e.g., +3.3 V) and a low data state, negative voltage (e.g., -3.3 V) to convey the data values being transmitted. However, the input signals may transition between other voltages in other embodiments.

When INN is at a low, negative voltage and INP is at a high, positive voltage, INN being at a low voltage makes PFET 507 conductive to pull the voltage of REFN1 to a lower voltage (the voltage of INN plus a voltage differential dependent on N1, but no less than the voltage differential above ground). REFN1 being at a lower voltage and INP being at a high voltage makes PFET 503 conductive. INP being at a high voltage controls the conductivity of PFET 509 to where the voltage of REFP1 is at a high voltage (the voltage of INP plus a voltage differential dependent on P1). REFP1 at a high voltage makes NFET 505 conductive. Thus, when INN is at a low voltage and INP is at a high voltage, both PFET 503 and NFET 505 are conductive to make passgate 501 conductive to provide signal INP (which is at a high data state voltage) as signal OP1.

INN being at a low voltage makes PFET 519 conductive to pull the voltage of REFN2 to a lower, non negative voltage (the voltage of INN plus a voltage differential dependent on N2, but no less than the voltage differential above ground). REFN2 being at a lower, non negative voltage and INN being at an even lower, negative voltage makes NFET 515 conductive. INP being at a high voltage controls the conductivity of PFET 517 to where the voltage of REFP2 is at a high voltage (the voltage of INP plus a voltage differential dependent on P2). REFP2 at a high voltage makes PFET 513 nonconductive. Thus, when INN is at a low, negative voltage and INP is at a high positive voltage, passgate 511 is conductive (through NFET 515) such that signal INN (which is at a low, negative data state voltage) is provided as signal ON1.

When INP is at a low, negative voltage and INN is at a high, positive voltage, INP being at a low voltage makes PFET 517 conductive to pull the voltage of REFP2 to a lower voltage (the voltage of INP plus a voltage differential dependent on P2, but no less than the voltage differential above ground). REFP2 being at a lower voltage and INN being at a high voltage makes PFET 513 conductive. INN being at a high voltage controls the conductivity of PFET 519 to where the voltage of REFN2 is at a high voltage (the voltage of INN plus a voltage differential dependent on N2). REFN2 at a high voltage makes NFET 515 conductive. Thus, when INP is at a low voltage and INN is at a high voltage, both PFET 513 and NFET 515 are conductive to make passgate 511 conductive to provide signal INN (which is at a high data state voltage) as signal ON1.

INP being at a low voltage makes PFET 509 conductive to pull the voltage of REFP1 to a lower, non negative voltage (the voltage of INP plus a voltage differential dependent on P1, but no less than the voltage differential above ground). REFP1 being at a low, non negative voltage and INP being at an even lower, negative voltage makes NFET 505 conductive. INN being at a high voltage controls the conductivity of PFET 507 to where the voltage of REFN1 is at a high voltage (the voltage of INN plus a voltage differential dependent on N1). REFN1 at a high voltage makes PFET 503 nonconductive. Thus, when INP is at a low, negative voltage and INN is at a high positive voltage, passgate 501 is conductive (through NFET 505) such that signal INP (which is at a low, negative data state voltage) is provided as signal OP1.

Because currents N1, P1, P2, and N2 can be adjusted to control the voltage differential between the voltages at the inputs of the source followers (INN, INP) and the voltages at the outputs of the source followers (REFN1, REFP1, REFP2, and REFN2), the currents can be adjusted to increase or decrease the impedance of the passgates 501 and 511 to increase or decrease, respectively the attenuation of attenuator 403.

For example, if the amount of current of N1 is raised and the amount of current of P1 is lowered, then the voltage differential of REFN1 to INN will be raised and the voltage differential of REFP1 to INP will be lowered. In such a condition, the conductivity of PFET 503 will be reduced in that the voltage of INN has to drop lower for PFET 503 to fully turn on. Also, the conductivity NFET 505 will be reduced in that the voltage of INP must go higher for NFET 505 to fully turn on. Thus, the impedance of passgate 501 will be raised in that PFET 503 and NFET 505 will be less conductive, thereby increasing the attenuation of passgate 501.

On the other hand, if the amount of current of N1 is lowered and the amount of current of P1 is raised, then the voltage differential between REFN1 to INN will be lowered and the voltage differential between REFP1 to INP will be raised. In such a condition, the conductivity of PFET 503 will increase in that the voltage of INN does not have to drop as far for PFET 503 to fully turn on. Also, the conductivity of NFET 505 will increase in that the voltage of INP does not have to go has high for NFET 505 to fully turn on. Thus, the impedance of passgate 501 will be lowered in that PFET 503 and NFET 505 will be more conductive, thereby decreasing the attenuation of passgate 501.

If the amount of current of P2 is raised and the amount of current of N1 is lowered, then the voltage differential of REFP2 to INP will be raised and the voltage differential of REFN2 to INN will be lowered. In such a condition, the conductivity of PFET 513 will be reduced in that the voltage of INP has to drop lower for PFET 513 to fully turn on. Also, the conductivity NFET 515 will be reduced in that the voltage of INN must go higher for NFET 515 to fully turn on. Thus, the impedance of passgate 511 will be increased in that PFET 513 and NFET 515 will be less conductive, thereby increasing the attenuation of passgate 511.

On the other hand, if the amount of current of P2 is lowered and the amount of current of N2 is raised, then the voltage differential between REFP2 to INP will be lowered and the voltage differential between REFN2 to INN will be raised. In such a condition, the conductivity of PFET 513 will increase in that the voltage of INP does not have to drop as far for PFET 513 to fully turn on. Also, the conductivity of NFET 515 will increase in that the voltage of INN does not have to go has high for NFET 515 to fully turn on. Thus, the impedance of passgate 511 will be lowered in that NFET 515 and PFET 513 will be more conductive, thereby decreasing the attenuation of passgate 511.

Attenuator 403 may have other configurations, use only types of devices, and/or include other types of circuits in other embodiments. For example, in Figure 5, the source followers are implemented with PFETs (507, 509, 517, and 519) receiving a current from a current source. However, in other embodiments, other types of source followers including source followers with other types of transistors (e.g., NFETs) and/or source followers of different configurations (e.g., a flipped source follower) may be used. Also, passgates of other configurations may be used as well.

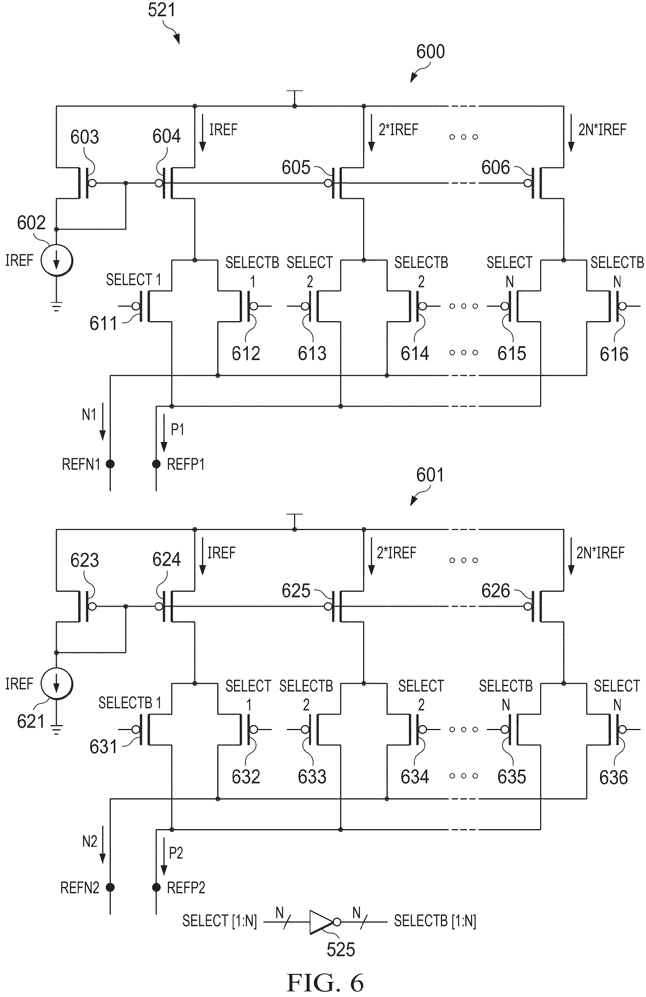

Figure 6 is a circuit diagram of programmable current source circuit 521 according to one embodiment of the present disclosure. In the embodiment shown, circuit 521 includes two identical current production circuits 600 and 601. Circuit 600 produces currents N1 and P1 and circuit 601 produces currents N2 and current P2.

Circuit 600 includes a reference current source 602 that produces current IREF. Circuit 600 includes a current mirror that includes PFETs 603-606 where PFETs 604-606 are of different sizes to produce currents at different ratios of IREF (e.g., IREF, 2*IREF, and 2N*IREF). Each of PFETs 604-606 are connected to two steering PFETs of PFETs 611-616 that control whether the current from that PFET of PFETs 604-606 is added to current N1 or added to current P1. For each steering PFET pair, one bit of the SELECT signal is connected to the gate of one of the steering PFETs of the pair and the corresponding bit of the inverse SELECTB signal is connected to the gate of the other steering PFET of the pair. For example, the pair of steering PFETs 611 and 612 are connected to PFET 604. The signal bit SELECT 1 is connected to the gate of PFET 611 and the inverse signal bit SELECTB 1 is connected to the gate of PFET 612. Thus, the current produced by PFET 604 is added to current N1 or current P1, depending upon the data state of bits SELECT 1/SELECTB 1.

Consequently, over the range of possible SELECT signal code combinations, current N1 will be inverse to current P2 in that their total sum (N1+P1) for each signal code combination will equal the maximum current generated through PFETs 604-606. For example, if the maximum amount of current generated by PFETs 604-606 is 10 mA and N1 is 2 mA, then P1 would be 8 mA. If N1 is 4 mA, then P1 would be 6 mA.

Circuit 601 is similar to circuit 600 where it includes a current source 621 that provides a current IREF and a current mirror of PFETs 623-626. Circuit 601 includes steering PFETs 631, 633, and 635 that are responsive to bits of the SELECTB signal to provide current P2 and PFETs 632, 634, and 636 that are responsive to bits of the SELECT signal to provide current N2. Accordingly, currents N2 and P2 are inverse to each other over the range of possible SELECT signal code combinations.

Because circuits 600 and 601 are similar where IREF is the same and PFETs 603-606 have the same corresponding sizes as PFETs 623-626, current N1 and current P2 are the same and current P1 and current N2 are the same.

In other embodiments, circuit 521 may include a production circuit for each current produced. Also in other embodiments, currents N1 and P1 would not be inverse to each and currents N2 and P2 would not be inverse to each other. In still other embodiments, current sources 602 and 621 would be adjustable to change the reference current IREF. In still other embodiments, the circuit would have other configurations. In some embodiments, the currents N1, P1, N2, and P2 produced by circuit 521 would not be adjustable. In some embodiments, circuit 521 would include for current sources (not shown) for producing N1, N2, P1, and P2.

Figure 7 is a table showing the voltage differentials between the inputs and outputs of the source followers of Figure 5 (implemented with PFETs 507, 509, 517, and 519) as determined by currents N1, P1, P2, and N2 whose values are set by the identified SELECT signal code value. The table also shows the total dB attenuation at 5 GHz at the output of the receiver produced with each signal code value. Each SELECT signal code value represents a unique combination of the SELECT signal bits and the SELECTB signal bits applied to circuits 600 and 601. For the table shown in Figure 5, the maximum value of INP is 300 mV and the minimum value of INN is -300 mV. However, these numbers may be different in other embodiments.

In some embodiments, the voltage differentials given in the Table of Figure 7 are the voltage differential values provided by the source followers of PFETs 507, 509, 517, and 519 when the gates of the PFETs are at 0 V (or at a common mode voltage) with respect to the currents of N1, P1, P2, and N2 provided at a specified SELECT code value. Because the gain of a source follower is not linear, and because the drains of PFETs 507, 509, 517, and 519 are tied to ground, the instantaneous voltage differentials may vary somewhat over the voltage ranges of the input signals (INP and INN) from the voltage differential values given in the table with respect to a specific code value. However, even with this variation, the voltage differentials provided at the different code values may vary for the same input voltage values so as to adjust the attenuation of the passgates for the different currents provided by each code value.

For code value 1, the voltage differential of REFP1 minus INP (REFP1-INP) and the voltage differential of REFN2 minus INN (REFN2-INN) is 550 mV. Also, for code value 1, the voltage differential of REFN1 minus INN (REFN1-INN) and the voltage differential of REFP2 minus INP (REFP2-INP) is 50 mV. At these voltages, the attenuator provides the output of the receiver with -2 dB attenuation at 5 GHz. As shown in the Table, as the voltage differentials of REFP1-INP and REFN2-INN decrease and the voltage differentials of REFN1-INN and REFP2-INP increase, the amount of attenuation increases in that the conductivity of the passgates decreases. For code value 11, the voltage differential of REFP1 minus INP (REFP1-INP) and the voltage differential of REFN2 minus INN (REFN2-INN) is 50 mV. Also, for code value 11, the voltage differential of REFN1 minus INN (REFN1-INN) and the voltage differential of REFP2 minus INP (REFP2-INP) is 550 mV. At these voltages, the attenuator provides the output of the receiver with -9 dB attenuation at 5 GHz.

In other embodiments, the voltage differentials and attenuation obtained values per each code setting may be different. Other embodiments may include a different number of SELECT code values (e.g., 27). Furthermore, the differential values per each code may be different. For example, REFP1-INP may be different form REFN2-INN for the same code setting. In other embodiments, each current N1, P1, N2, and P2 may be individually settable with different code values. In still other embodiments, the range of attenuation provided by circuit 521 may be different. For example, in some embodiments, circuit 521 may set the currents to provide an attenuation from 0 dB to -10 dB at .5 dB increments. Also, the currents may be set to provide the desired attenuation values at different frequencies.

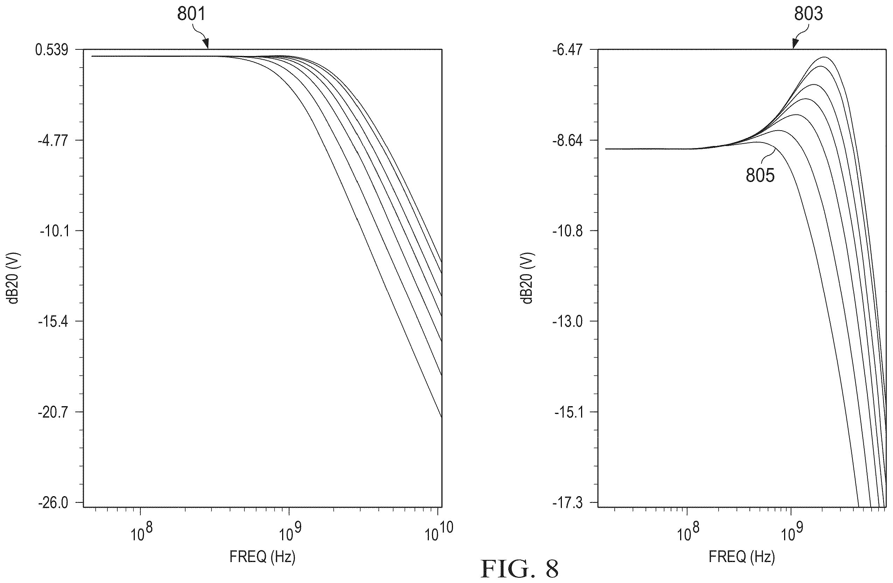

Figure 8 shows graph 801 showing the frequency response of an attenuator similar to attenuator 403. Graph 801 shows the frequency response for seven different SELECT signal codes, where each code provides a different frequency response with a varied degree of attenuation at the higher frequencies.

Figure 8 shows a graph of the frequency response at the receiver output as per each of the seven codes. As shown in graph 803, the SELECT code corresponding to frequency response 805 provides the most reduced gain bump at the higher frequencies. Accordingly in some embodiments, it would be most desirable to operate a receiver at that SELECT code value.

As described herein, an attenuator that utilizes passgates and source followers to achieve signal attenuation may provide for an attenuator that does not require large capacitors or resistances as in typical low pass filters. Furthermore, such a circuit may minimize parasitics found in typical low pass filter attenuators. Also, providing an attenuator with a programmable current source circuit may allow for the attenuator to be used in many different conditions including with different channels, different channel lengths, at different frequencies, and with different signal voltages. Furthermore, in some embodiments, the attenuation can be adjusted during operation to provide optimum data quality.

The attenuators shown and described herein may be used in receivers for any number of different communication channels such as is in wired and wireless systems and/or used for any number of different communication protocols (e.g., SerDes, USB, PCI, Ethernet). Furthermore, an attenuators shown and described herein may be used in other circuits for providing attenuation to a signal. The attenuators may be used in any one of a number of applications such as e.g., computers, cell phones, automotive electronics, wearables, IOT systems, industrial, embedded systems, or communications systems.

As used herein, one item is "coupled" to another item either by being connected to the other item or by being coupled in a current path through at least one further item. For example, in Figure 6, the drain of PFET 604 is coupled to the node producing REFP1 through PFET 611. The drain of PFET 604 is also coupled to PFET 612 by being connected to it. A gate is a control terminal of a FET. A drain and source are current terminals of a FET.

In one embodiment, a circuit includes a first input terminal, configured to receive a first input signal and a second input terminal, configured to receive a second input signal, wherein the first input signal and the second input signal are differential signals to each other. The circuit includes a first output terminal configured to provide a first output signal. The circuit includes a first passgate including a first transistor of a first conductivity type and a second transistor of a second conductivity type coupled in parallel with the first transistor, wherein a first current terminal of the first transistor and a first current terminal of the second transistor are coupled together and are coupled to the first input terminal to receive the first input signal, wherein a second current terminal of the first transistor and a second current terminal of the second transistor are coupled together and coupled to the first output terminal to provide the first output signal. The circuit includes a third transistor including a first current terminal coupled to a control terminal of the second transistor, the third transistor including a control terminal coupled to the first input terminal to receive the first input signal. The circuit includes a fourth transistor including a first current terminal coupled to the control terminal of the first transistor, the fourth transistor including a control terminal coupled to the second input terminal to receive the second input signal.

In a further embodiment, the circuit includes a second output terminal configured to provide a second output signal, wherein the first output signal and the second output signal are differential signals to each other. The circuit includes a second passgate including a fifth transistor of the first conductivity type and a sixth transistor of the second conductivity type coupled in parallel with the fifth transistor, wherein a first current terminal of the fifth transistor and a first current terminal of the sixth transistor are coupled together and are coupled to the second input terminal to receive the second input signal, wherein a second current terminal of the fifth transistor and a second current terminal of the sixth transistor are coupled together and coupled to the second output terminal to provide the second output signal. The circuit includes a seventh transistor including a first current terminal coupled to a control terminal of the sixth transistor, the seventh transistor including a control terminal coupled to the second input terminal to receive the second input signal. The circuit includes an eight transistor including a first current terminal coupled to the control terminal of the fifth transistor, the eight transistor including a control terminal coupled to the first input terminal to receive the first input signal.

In a further embodiment, the circuit includes a current source circuit, wherein the first current terminal of the third transistor is configured to receive a first current generated by the current source circuit, the first current terminal of fourth transistor is configured to receive a second current generated by the current source circuit, the first current terminal of the seventh transistor is configured to receive a third current generated by the current source circuit, and the first current terminal of the eight transistor is configured to receive a fourth current generated by the current source circuit.

In a further embodiment, the first current and the second current are each programmable to adjust an attenuation of the first output signal with respect to the first input signal by the first passgate, and the third current and the fourth current are each programmable to adjust an attenuation of the second output signal with respect to the second input signal by the second passgate.

In a further embodiment, the circuit includes a controller. The first passgate and the second passgate are implemented in a receiver, wherein the first input signal and the second input signal are representative of signals received by the receiver over a communications channel, wherein the controller is configured to adjust the first current, the second current, the third current, and the fourth current based on at least one measured quality parameter of the signals received by the receiver.

In a further embodiment, the at least one measured quality parameter includes at least one of a group consisting of a bit error rate, data jitter, signal to noise ratio, data eye height, and data eye width.

In a further embodiment, the current source circuit is configured to provide the first current and the third current at a same current amount and configured to provide the second current and the fourth current at the same current amount.

In a further embodiment, the first transistor is characterized as PFET, the second transistor is characterized as an NFET, the third transistor is characterized as a PFET, the fourth transistor is characterized as PFET, the fifth transistor is characterized as PFET, the sixth transistor is characterized as an NFET, the seventh transistor is characterized as a PFET, and the eight transistor is characterized as a PFET.

In a further embodiment, the third transistor is implemented in a first source follower wherein the first current terminal of the third transistor provides an output voltage of the first source follower to control the voltage of the control terminal of the second transistor, and the fourth transistor is implemented in a second source follower wherein the first current terminal of the fourth transistor provides an output voltage of the second source follower to control the voltage of the control terminal of the first transistor.

In a further embodiment, the first current terminal of the third transistor is configured to receive a first current generated by a current source circuit, and the first current terminal of fourth transistor is configured to receive a second current generated by the current source circuit, the first current and the second current are programmable, and the first current and the second current are programmable at different settings such that the first current is inverse with the second current over the different settings.

In a further embodiment, the third transistor and the fourth transistor are of the first conductivity type.

In a further embodiment, the first passgate is implemented in a receiver, wherein the first input signal and the second input signal are representative of signals received by the receiver over a communications channel.

In a further embodiment, the first input signal and the second input signal each range from a negative voltage to a positive voltage.

In another embodiment, a method includes providing a first input signal to a first current terminal of a first passgate and providing a second input signal to a first current terminal of a second passgate, the first input signal and the second input signal are differential signals to each other, the first passgate includes a first transistor and a second transistor, the first transistor being of a first conductivity type and the second transistor being a second conductivity type opposite the first conductivity type, the second passgate includes a third transistor and a fourth transistor, the third transistor being of the first conductivity type and the second transistor being of the second conductivity type. The method includes controlling a control terminal voltage of the first transistor with an output of a first source follower, an input of the first source follower receives the second input signal. The method includes controlling a control terminal voltage of the second transistor with an output of a second source follower, an input of the second source follower receives the first input signal. The method includes controlling a control terminal voltage of the third transistor with an output of a third source follower, an input of the third source follower receives the first input signal. The method includes controlling a control terminal voltage of the fourth transistor with an output of a fourth source follower, an input of the fourth source follower receives the second input signal. The method includes providing a first output signal at a second current terminal of the first passgate and providing a second output signal at a second current terminal of the second passgate, wherein the first output signal and the second output signal are differential signals to each other.

In a further embodiment, the method includes generating a first current for the first source follower, generating a second current for the second source follower, generating a third current for the third source follower, generating a fourth current for the fourth source follower, wherein the first current and the third current are of a same current value, wherein the second current and the fourth current are of a same current value.

In a further embodiment, the method includes generating a first current for the first source follower, generating a second current for the second source follower, generating a third current for the third source follower, and generating a fourth current for the fourth source follower. The first current and the second current are each programmable to adjust an attenuation of the first output signal with respect to the first input signal by the first passgate. The third current and the fourth current are each programmable to adjust an attenuation of the second output signal with respect to the second input signal by the second passgate.

In a further embodiment, the first current and the second current are programmable at a plurality of different settings, wherein the first current and the second current are inverse over the plurality of different settings, and the third current and the fourth current are programmable at a plurality of different settings, wherein the third current and the fourth current are inverse over the plurality of different settings.

In a further embodiment, the first input signal and the second signal are representative of signals received by a receiver over a communications channel, The method further includes adjusting the first current, the second current, the third current and the fourth current based on at least one measured quality parameter of the signals received by the receiver.

In a further embodiment, the at least one measured quality parameter includes at least one of a group consisting of data jitter, signal to noise ratio, bit error rate, data eye height, and data eye width.

In another embodiment, a circuit includes a first input terminal, configured to receive a first input signal, and a second input terminal, configured to receive a second input signal, wherein the first input signal and the second input signal are differential signals to each other. The circuit includes a first output terminal configured to provide a first output signal, and a second output terminal configured to provide a second output signal, wherein the first output signal and the second output signal are differential signals to each other. The circuit includes a first passgate including a first transistor of a first conductivity type and a second transistor of a second conductivity type coupled in parallel with the first transistor, wherein a first current terminal of the first transistor and a first current terminal of the second transistor are coupled together and are coupled to the first input terminal to receive the first input signal, wherein a second current terminal of the first transistor and a second current terminal of the second transistor are coupled together and coupled to the first output terminal to provide the first output signal. The circuit includes a first source follower including an output coupled to a control terminal of the second transistor and including an input coupled to the first input terminal to receive the first input signal, and a second source follower including an output coupled to the control terminal of the first transistor and including an input coupled to the second input terminal to receive the second input signal. The circuit includes a second passgate including a third transistor of the first conductivity type and a fourth transistor of the second conductivity type coupled in parallel with the third transistor, wherein a first current terminal of the third transistor and a first current terminal of the fourth transistor are coupled together and are coupled to the second input terminal to receive the second input signal (INN), wherein a second current terminal of the third transistor and a second current terminal of the fourth transistor are coupled together and coupled to the second output terminal to provide the second output signal. The circuit includes a third source follower including an output coupled to a control terminal of the fourth transistor and including an input coupled to the second input terminal to receive the second input signal, and a fourth source follower including an output coupled to the control terminal of the third transistor and including an input coupled to the first input terminal to receive the first input signal.

Features specifically shown or described with respect to one embodiment set forth herein may be implemented in other embodiments set forth herein.

While particular embodiments of the present disclosure have been shown and described, it will be recognized to those skilled in the art that, based upon the teachings herein, further changes and modifications may be made without departing from this disclosure and its broader aspects, and thus, the appended claims are to encompass within their scope all such changes and modifications as are within the scope of this disclosure.

## Claims

1. A circuit, comprising:
a first input terminal, configured to receive a first input signal;
a second input terminal, configured to receive a second input signal, wherein the first input signal and the second input signal are differential signals to each other;
a first output terminal configured to provide a first output signal;
a first passgate including a first transistor of a first conductivity type and a second transistor of a second conductivity type coupled in parallel with the first transistor, wherein a first current terminal of the first transistor and a first current terminal of the second transistor are coupled together and are coupled to the first input terminal to receive the first input signal, wherein a second current terminal of the first transistor and a second current terminal of the second transistor are coupled together and coupled to the first output terminal to provide the first output signal;
a third transistor including a first current terminal coupled to a control terminal of the second transistor, the third transistor including a control terminal coupled to the first input terminal to receive the first input signal;
a fourth transistor including a first current terminal coupled to the control terminal of the first transistor, the fourth transistor including a control terminal coupled to the second input terminal to receive the second input signal.

2. The circuit of claim 1 further comprising:
a second output terminal configured to provide a second output signal, wherein the first output signal and the second output signal are differential signals to each other;
a second passgate including a fifth transistor of the first conductivity type and a sixth transistor of the second conductivity type coupled in parallel with the fifth transistor, wherein a first current terminal of the fifth transistor and a first current terminal of the sixth transistor are coupled together and are coupled to the second input terminal to receive the second input signal, wherein a second current terminal of the fifth transistor and a second current terminal of the sixth transistor are coupled together and coupled to the second output terminal to provide the second output signal;
a seventh transistor including a first current terminal coupled to a control terminal of the sixth transistor, the seventh transistor including a control terminal coupled to the second input terminal to receive the second input signal;
an eight transistor including a first current terminal coupled to the control terminal of the fifth transistor, the eight transistor including a control terminal coupled to the first input terminal to receive the first input signal.

3. The circuit of claim 2 further comprising:
a current source circuit, wherein the first current terminal of the third transistor is configured to receive a first current generated by the current source circuit, the first current terminal of fourth transistor is configured to receive a second current generated by the current source circuit, the first current terminal of the seventh transistor is configured to receive a third current generated by the current source circuit, and the first current terminal of the eight transistor is configured to receive a fourth current generated by the current source circuit.

4. The circuit of claim 3 wherein:
the first current and the second current are each programmable to adjust an attenuation of the first output signal with respect to the first input signal by the first passgate;
the third current and the fourth current are each programmable to adjust an attenuation of the second output signal with respect to the second input signal by the second passgate.

5. The circuit of claim 3 further comprising:
a controller;
the first passgate and the second passgate are implemented in a receiver, wherein the first input signal and the second input signal are representative of signals received by the receiver over a communications channel, wherein the controller is configured to adjust the first current, the second current, the third current, and the fourth current based on at least one measured quality parameter of the signals received by the receiver.

6. The circuit of claim 5 wherein the at least one measured quality parameter includes at least one of a group consisting of a bit error rate, data jitter, signal to noise ratio, data eye height, and data eye width.

7. The circuit of claim 3 wherein the current source circuit is configured to provide the first current and the third current at a same current amount and configured to provide the second current and the fourth current at the same current amount.

8. The circuit of claim 2 wherein the first transistor is characterized as PFET, the second transistor is characterized as an NFET, the third transistor is characterized as a PFET, the fourth transistor is characterized as PFET, the fifth transistor is characterized as PFET, the sixth transistor is characterized as an NFET, the seventh transistor is characterized as a PFET, and the eight transistor is characterized as a PFET.

9. The circuit of any of the preceding claims, wherein:
the third transistor is implemented in a first source follower wherein the first current terminal of the third transistor provides an output voltage of the first source follower to control the voltage of the control terminal of the second transistor;
the fourth transistor is implemented in a second source follower wherein the first current terminal of the fourth transistor provides an output voltage of the second source follower to control the voltage of the control terminal of the first transistor.

10. The circuit of any of the preceding claims, wherein:
the first current terminal of the third transistor is configured to receive a first current generated by a current source circuit, and the first current terminal of fourth transistor is configured to receive a second current generated by the current source circuit;
the first current and the second current are programmable;
the first current and the second current are programmable at different settings such that the first current is inverse with the second current over the different settings.

11. The circuit of any of the preceding claims, wherein the third transistor and the fourth transistor are of the first conductivity type.

12. The circuit of any of the preceding claims , further comprising:
the first passgate is implemented in a receiver, wherein the first input signal and the second input signal are representative of signals received by the receiver over a communications channel.

13. The circuit of any of the preceding claims, wherein the first input signal and the second input signal each range from a negative voltage to a positive voltage.

14. A method comprising:
providing a first input signal to a first current terminal of a first passgate and providing a second input signal to a first current terminal of a second passgate, the first input signal and the second input signal are differential signals to each other, the first passgate includes a first transistor and a second transistor, the first transistor being of a first conductivity type and the second transistor being a second conductivity type opposite the first conductivity type, the second passgate includes a third transistor and a fourth transistor, the third transistor being of the first conductivity type and the second transistor being of the second conductivity type;
controlling a control terminal voltage of the first transistor with an output of a first source follower, an input of the first source follower receives the second input signal;
controlling a control terminal voltage of the second transistor with an output of a second source follower, an input of the second source follower receives the first input signal;
controlling a control terminal voltage of the third transistor with an output of a third source follower, an input of the third source follower receives the first input signal;
controlling a control terminal voltage of the fourth transistor with an output of a fourth source follower, an input of the fourth source follower receives the second input signal;
providing a first output signal at a second current terminal of the first passgate and providing a second output signal at a second current terminal of the second passgate, wherein the first output signal and the second output signal are differential signals to each other.

15. The method of claim 14 further comprising:
generating a first current for the first source follower;
generating a second current for the second source follower;
generating a third current for the third source follower;
generating a fourth current for the fourth source follower;
wherein the first current and the third current are of a same current value;
wherein the second current and the fourth current are of a same current value.
